Europäisches Patentamt

European Patent Office

Office européen des brevets

(19)

(11) **EP 1 168 529 A1**

(12) **EUROPEAN PATENT APPLICATION**
published in accordance with Art. 158(3) EPC

(43) Date of publication:
**02.01.2002 Bulletin 2002/01**

(21) Application number: **98959323.1**

(22) Date of filing: **04.11.1998**

(51) Int Cl.7: **H01S 3/00**

(86) International application number:
**PCT/RU98/00363**

(87) International publication number:
**WO 00/27002 (11.05.2000 Gazette 2000/19)**

(84) Designated Contracting States:
**AT BE CH CY DE DK ES FI FR GB GR IE IT LI LU MC NL PT SE**

(71) Applicant: **Laserlab Research Ltd.**
**52511 Ramat-Gan (IL)**

(72) Inventors:
• **SOLODOVNIKOV, Vladimir Vadimovich**
**Noginsky R-N, Moskovskaya obl.,142432 (RU)**

• **LAVROV, Anatoly Fedorovich**
**Moscow, 117342 (RU)**

(74) Representative: **Modiano, Guido, Dr.-Ing. et al**
**Modiano, Josif, Pisanty & Staub, Baaderstrasse 3**
**80469 München (DE)**

(54) **RADIATING ADDER**

(57)    The present invention pertains to the field of radiation sources mainly based on laser diodes. The radiating adder of the present invention includes a plurality of sources (1) comprising radiating areas having a strip-type geometry, as well as a radiation generating system (3) that comprises collimation (6, 8), transfer (7) and focalisation (4) means. The transfer means (7) is capable of compounding the radiations from the plurality of sources. The sources (1) are arranged at a distance, relative to the focalisation area, that corresponds to the optical length L with a deviation $\Delta L$ not exceeding 10 %. The focalisation area (4) can further include at least partially reflective means (9). The brightness can thus be increased together with the output power.

FIG.2

EP 1 168 529 A1

**Description**

Field of the Invention

The present invention relates to high brightness, high power output density light sources and is particularly concerned with light sources using laser diodes.

Description of the Prior Art

One of the problems of great importance in laser engineering consists in providing coherent light source having high brightness and high power output density wherein such light could be coupled e.g. into an optical fibre of 50 mu diameter.

Known are various structures of high brightness light-emitting adders (see WO92/02844A1, 1992, G02B 27/00, H01S 3/094, and US005319528A, 1994, F21V 7/04, 362/32), including those comprising laser diodes. In these systems, individual sources have a stripe-geometry emission region in the cross-sectional plane perpendicular to the optical axis of the respective source. In order to fit the light energy e.g. into an optical fibre, it is necessary to obtain a substantially circular spot on the target area thus reducing the energy loss. The conventional structures, as well as that described in the paper by T.Y. Fan and Antonio Sanchez, IEEE Journal of Quantum Electronics (1990), Vol. 26, No. 2, pp. 311-316, use anamorphic, collimating and shaping means ensuring a quasi total illumination of the target area while having isolated regions of each source's beams propagation within the acceptance angle from the focusing means to the focusing zone where said target area is located.

Another light-emitting adder disclosed in US005463534A, 1995, F04V 7/04, 362/32, comprises at least two light sources with identical stripe geometry of the emission regions. The light-emitting stripes of the output ends have their mutually perpendicular sides with a long dimension and a short dimension in the cross-sections perpendicular to the optical axes of the light sources. Said light sources are spaced apart from the focusing zone at distances equal to the optical lengths L as calculated from each individual source to the focusing zone, taking into account the refractive indices of the medium along the beam path (see Handbook of General Physics, Vol. 3, G.S. Landsberg, "Optics", State Publishing House for Engineering and Theoretical Literature, Moscow, 1952, p. 84). In the above-mentioned known system, the optical lengths L, mu, differ from source to source.

Provided between the light sources and the focusing zone are imaging means comprising beam shaping means allowing to collimate the beam in mutually perpendicular directions parallel to the sides of the light-emitting stripe, and focusing means to focus the collimated beams onto the focusing zone accommodating the target area.

In such a light-emitting adder, the required illumination of the target area is obtained with the aid of cylindrical telescopes, as well as collimating and focusing means included in said imaging means, said focusing means having substantially equal focal lengths in x-axis and y-axis. The inventors emphasized the fact that within the acceptance angle between the focusing means and the target area, the beams emitted by each light source occupy well definite different spaces without propagating through the adjacent regions. Consequently, the resultant beam will include, as regards its spectral parameters and wavelengths, the entire spread characteristic of the individual light sources. Problems then arise, especially in the case of laser diodes, in achieving a maximum output brightness with a minimum number of original light sources used, such problems being particularly critical when need is felt to deliver the light energy into an optical fibre.

Summary of the Invention

The invention aims to provide a light-emitting adder with, on the one hand, increased brightness and power output density and, on the other hand, reduced energy loss along the optical path and while illuminating the target area and/or at least partly reflecting means, there being additionally provided the possibility of self-adjustment of said adder, its increased efficiency at different wavelengths. simplified beam positioning and manufacturing process, as well as the ease of implementation.

According to a first embodiment of the invention, these objects are attained in a light-emitting adder comprising at least two light sources with stripe-geometry emission regions in the sections perpendicular to the optical axes of said light sources, the mutually perpendicular sides of the light-emitting stripes at the output ends of said light sources having a long dimension and a short dimension, a target area and imaging means interposed between said light sources and a focusing zone and including beam-shaping means provided with means for collimating beams in mutually perpendicular directions parallel to the sides of said light-emitting stripes, as well as focusing means for focusing onto said focusing zone, the output end of each light source being spaced apart from said focusing zone at distances equal to the optical lengths L, mu, wherein said light sources are selected in order to allow the emission at one at least wavelength $\lambda$, mu, and are located in a plane perpendicular to the long dimension of said light-emitting stripes, the values of optical lengths are selected within the range L - $\Delta$L ... L + $\Delta$L, where the deviation $\Delta$L, mu, of the optical lengths is taken so as not to exceed 10 % of said optical lengths L, mu, said beam-shaping means are provided, at the light sources' end and for each of them, with means for collimating beams in the direction parallel to the short dimension of each stripe, there is further provided at least one beam-transporting means capable, on at least a part of its extent, of mixing the beams, and downstream of said beam-transporting means within said beam-shaping means there are positioned means for collimating beams in the direction parallel to the long dimension of the stripe.

In certain cases, such a light-emitting adder may comprise light sources made in the form of either stripe-shaped laser diodes or stripe-shaped superluminescent diodes.

The distinctive features of the proposed light-emitting adders consist in essential structural particulars such as a group of laser diodes located in a same plane perpendicular to the long dimension of the light-emitting stripes and passing through the optical axis of the adder, and the provision of beam-shaping means having spaced-apart means ensuring the collimation along different axes parallel to the respective sides of said stripes with beam-transporting means placed therebetween, as well as in the selection of substantially equal optical lengths L, mu, differing from one another by predetermined deviations ±ΔL, mu, depending on the kind of the light source, these distinctive features resulting, when taken in combination, in new performances and output characteristics of the light-emitting adder such as increased brightness and power output density with, at the same time, a lower number of light sources, simplified manufacturing process and beam positioning, and lesser energy loss.

In accordance with one of the solutions, the objects of the invention are accomplished due to the fact that the optical lengths of different light sources are taken such that they differ from one another not more than by a value ΔL, mu, lying in the range of 2 to 8 % of said optical lengths L, mu, thereby achieving an increase in the brightness and the power output density.

In accordance with an alternative solution, the same objects are achieved owing to the fact that in light sources made in the form of laser diodes, the combination of deviations ΔL, mu, of the optical lengths and deviations δλ, mu, of the wavelengths, for at least one pair of laser diodes located symmetrically about the adder's optical axis, is taken so as to satisfy the coherence condition, i.e. $\Delta L \le \pi \cdot \lambda^2 / 8 \cdot \delta\lambda$ (see paper by Kolomiytsev "Interferometers", "Mashinostroyeniye" publishers, Leningrad Division, 1979, p. 85), thus leading, here again, to an increase in the brightness and the power output density.

As found in the course of experiments, with the adopted range of variations of the optical lengths L - ΔL ... L + ΔL, mu, and also, in relation to laser diodes, of the wavelengths λ, mu, the specific design of the beam-shaping means, provided with beam-transporting means capable of partially mixing beams from different light sources, allows to obtain a regular illumination of the target area positioned within the focusing zone. In such a system, the brightness in the centre of the spot is substantially the same as at its periphery and in the case of e.g. optical fibre, the total required emissive power will be delivered across its whole diameter.

According to a second embodiment of the invention, the above-stated objects are attained in a light-emitting adder comprising at least two light sources with stripe-geometry emission regions in the sections perpendicular to the optical axes of said light sources, the mutually perpendicular sides of the light-emitting stripes at the output ends of said light sources having a long dimension and a short dimension, a target area and imaging means interposed between said light sources and a focusing zone and including beam-shaping means provided with means for collimating beams in mutually perpendicular directions parallel to the sides of said light-emitting stripes, as well as focusing means for focusing onto said focusing zone, the output end of each light source being spaced apart from said focusing zone at distances equal to the optical lengths L, mu, wherein said light sources made in the form of laser diodes are selected in order to allow the emission at one at least wavelength λ, mu, and are located in a plane perpendicular to the long dimension of said light-emitting stripes, said beam-shaping means are provided, at the laser diodes' end and for each of them, with means for collimating beams in the direction parallel to the short dimension of each stripe, there is also provided at least one beam-transporting means capable, on at least a part of its extent, of mixing the beams, there is positioned, downstream of said beam-transporting means within said beam-shaping means, collimating means for collimating beams in the direction parallel to the long dimension of the stripes, and there is further provided, in said focusing zone, at least partly reflecting means, the values of optical lengths L, mu, being selected within the range L - ΔL ... L + ΔL, where ΔL, mu, is deviation of said optical lengths L, mu, and the combination of deviations ΔL, mu, of the optical lengths and deviations δλ, mu, of the wavelengths, for at least one pair of laser diodes located symmetrically about the adder's optical axis, being taken so as to satisfy the coherence condition, i.e. $\Delta L \le \pi \cdot \lambda^2 / 8 \cdot \delta\lambda$, whereas for the remaining laser diodes, the deviation ΔL, mu, of the optical lengths is taken so as not to exceed 10 % of said optical lengths L, mu.

This second embodiment of the light-emitting adder, possessing the same essential features as the first one, with the difference consisting in the laser diodes selected as light sources and in the deviations ΔL, mu, of the optical lengths and δλ, mu, of the wavelengths, which are taken, for at least two laser diodes, so as to satisfy the coherence condition, differs from said first embodiment by the provision of at least partly reflecting means allowing to improve the characteristics of the symmetric emitters due to their reciprocal influence, thus enabling, combined with the proposed beam-shaping means, the self-adjustment of the entire light-emitting adder and, hence, of the totality of laser diodes. This results in the following new performances and output characteristics of the light-emitting adders.

The suggested ranges of differences of wavelengths and optical lengths of the laser diodes chosen in order to satisfy the coherence condition, as well as the adopted arrangement of the structural components used, allow to obtain an integrated, substantially coherent light beam of required diameter and brightness. It is just in the beam-transporting means, namely in the plane perpendicular to the long dimension of the light-emitting stripes, that the individual collimated coherent beams emitted by each source are brought into a well packed integrated light beam characterized by a predetermined, at least partial mixing of the adjacent beams on at least a part of the path within said beam-transporting means. After having passed through said beam-transporting means, the resulting integrated beam is collimated in the perpendicular plane and has substantially equal optical lengths over the entire cross-section. Such an integrated beam produced in the proposed unique structure can be considered, to a very low degree of approximation, as a single beam. Moreover, the provision of at least partly reflecting means leads as well to an increased coherence of the integrated light beam over its entire cross-section. Therefore, thanks to the above unobvious and novel essential features of the light-emitting adders, it becomes possible to considerably enhance the brightness and the concentration of the beam in the centre of the focusing zone with a very low divergence on the periphery of the resulting spot.

According to a third embodiment of the invention, the above-stated objects are achieved in a light-emitting adder comprising at least two light sources with stripe-geometry emission regions in the sections perpendicular to the optical axes of said light sources, the mutually perpendicular sides of the light-emitting stripes at the output ends of said light sources having a long dimension and a short dimension, a target area and imaging means interposed between said light sources and a focusing zone and including beam-shaping means provided with means for collimating beams in mutually perpendicular directions parallel to the sides of said light-emitting stripes, as well as focusing means for focusing onto said focusing zone, the output end of each light source being spaced apart from said focusing zone at distances equal to the optical lengths L, mu, wherein at least two additional light sources are provided, all the light sources are made in the form of laser diodes, selected in order to allow the emission at one at least wavelength $\lambda$, mu, and arranged so as to have at least two sources in each of two mutually perpendicular planes, each of these planes being perpendicular to the long dimension of the respective light-emitting stripes, said imaging means comprise, in addition to said first beam-shaping means, second beam-shaping means, both said beam-shaping means being coupled to at least two light sources and provided, at said sources' end and for each of them, with means for collimating beams in the direction parallel to the short dimension of the light-emitting stripe, said first beam-shaping means further includes at least one beam-transporting means capable, on at least a part of its extent, of mixing the beams, said second beam-shaping means also incorporate at least one beam-transporting means capable, on at least a part of its extent, of mixing the beams, there is positioned, downstream of said beam-transporting means within each of said beam-shaping means, one collimating means for collimating beams in the direction parallel to the long dimension of the light-emitting stripes, the respective optical axes of said beam-shaping means being mutually perpendicular and there being additionally provided, at their intersection downstream of said beam-shaping means, a polarizer allowing, during the operation of the apparatus, to transmit the collimated beam from one of said beam-shaping means, to cause the total internal reflection of the collimated beam from other of said beam-shaping means, and to obtain a resulting beam on whose axis, downstream of said polarizer, said focusing means are mounted, whereas in said focusing zone there is placed at least partly reflecting means, the values of optical lengths L, mu, being selected within the range L - $\Delta$L ... L + $\Delta$L, where $\Delta$L, mu, is deviation of said optical lengths L, mu, and the combination of deviations $\Delta$L, mu, of the optical lengths and deviations $\delta\lambda$, mu, of the wavelengths, for at least one pair of laser diodes located symmetrically about the adder's optical axis, being taken so as to satisfy the coherence condition, i.e. $\Delta L \leq \pi \cdot \lambda^2 / 8 \cdot \delta\lambda$, whereas for the remaining laser diodes, the deviation $\Delta$L, mu, of the optical lengths is taken so as not to exceed 10 % of said optical lengths L, mu.

The above third embodiment of the light-emitting adder, possessing the same essential features as the second one, is distinguished therefrom by the structural novelty implying the use of a polarizer for its designated purpose. However, this becomes only possible due to the following essential features of the system: suitable choice of laser diodes; their provision in each of the planes and appropriate relative positioning of these planes; proper design of the beam-shaping means enabling to obtain substantially equal optical lengths L, mu, taking into account the deviations $\Delta$L, mu, and $\delta\lambda$, mu, satisfying the coherence condition; producing two well-packed substantially coherent integrated light beams in the beam-shaping means provided with beam-transporting means, as well as due to the provision of at least partly reflecting means positioned within the focusing zone. Should even one of the claimed features of the invention is not fulfilled, the degree of polarization of each resultant beam leaving the corresponding beam-shaping means 3 will be considerably reduced thus making the use of the polarizer quite ineffective.

To achieve the above-stated objects, all the three embodiments of the invention provide also that said beam-transporting means are designed with a degree of mixing ranging from 10 % to 40 %, thereby increasing the brightness and the power output density.

Furthermore, in all the three embodiments, beam-transporting means are provided on the trajectory of each light beam, thus leading, here again, to increased brightness and power output density due to the possibility of the self-adjustment of the adder, as well as to an increase in the coupling factor and to the simplification of the beam positioning operation and of the manufacturing process.

With the adopted degree of mixing in the beam-transporting means equal to 10 % ... 40 %, the beams leaving the sources overlap to a large extent within the acceptance angle downstream of the focusing means and overlap fully in proximity of the focusing zone. The focusing zone is wholly illuminated by each beam of the source, thereby allowing to obtain a substantially uniform illumination of this zone and, hence, of said at least partly reflecting means 9 placed therein according to the second and third embodiments of the invention.

In addition, all the three embodiments provide that said beam-transporting means may be made with a predetermined variation of the degree of mixing, at least in the plane perpendicular to the long dimension of the light-emitting stripes and in at least one direction, one the solutions, valid for all the three embodiments, providing that said beam-transporting means may be formed with a predetermined variation of the refractive index. As a result, it becomes possible to reduce the energy loss along the optical path and when illuminating the target area and/or said at least partly reflecting means, as well as to simplify the beam positioning operation.

Besides, the provision of said beam-transporting means allows to render less stringent the requirements placed upon the adjustment of individual emitters, thus simplifying the manufacturing process. The resulting adder assumes a compact appearance with reduced overall dimensions while improving at the same time its principal characteristics, such as the brightness and the power output density.

The objects of the invention are achieved, in all the three embodiments, due to the fact that the number N of sources is taken, within the acceptable range of variations between 0.5N and 1.5N, integral-valued subject to the condition:

$$N = [b \cdot \sin(\theta_b/2)] / [a \cdot \sin(\theta_a/2)],$$

where a and b are dimensions of the stripe-shaped emission regions of the source for the long side and the short side, respectively, and

$\theta_a$ and $\theta_b$ are divergence angles in the direction of the long dimension and the short dimension, respectively.

In such a system, energy loss are lowered along the optical path and when illuminating the target area and/or said at least partly reflecting means, the number of sources used being also reduced.

In all the three embodiments, the light sources are arranged in such a manner that the centres of their emitting stripes are located in the plane perpendicular to the long dimension of said stripes. In addition, the target area may be placed within the focusing zone. All the above provisions result in achieving a maximum brightness.

The second and the third embodiments of the invention provide that the planes of said target area and said at least partly reflecting means are made coincident with one another, thus simplifying the manufacturing process and making easier the implementation of the light-emitting adder.

In all the three embodiments, the laser diodes are made with wavelengths λ, mu, and optical lengths L, mu, such that for any pair of laser diodes located symmetrically about the optical axis of the adder, the combination of deviations ΔL, mu, of the optical lengths and deviations δλ, mu, of the wavelengths satisfies the coherence condition, i.e. $\Delta L \leq \pi \cdot \lambda^2 / 8 \cdot \delta\lambda$.

The above condition allows, when combined with the provision of said at least partly reflecting means, the proposed design of the beam-shaping means producing a well-packed light beam and the adopted arrangement of the laser diodes, to obtain an integrated, substantially coherent light beam leaving said beam-shaping means and to achieve the influence of the symmetric laser diodes on one another, as well as on the self-adjustment of the adder taken as a whole, thereby increasing the brightness, the power output density and the concentration of the beam energy in the centre of the focusing zone.

As an additional measure aimed at solving the above-stated problems, it is suggested that at least one of the laser diodes be made with the lowest divergence angles $\theta_a$, $\theta_b$ and spectral half-width. Besides, said laser diode is positioned on the optical axis of the adder, while other diodes are arranged symmetrically with respect to the former.

Such a solution makes it possible not only to enhance the brightness and the power output density and to ensure the self-adjustment of the adder, but also to simplify the manufacturing process.

Within the framework of the solutions under consideration, said laser diode having the lowest divergence angles $\theta_a$, $\theta_b$ and spectral half-width is advantageously of single-mode type, thus leading, owing to the possibility of self-adjustment of the adder, to an increase in the brightness and the power output density.

It expedient, for all the three embodiments of the invention, to made the laser diodes with at least two values of wavelengths. In such a system, a version is possible where at least one beam-shaping means are associated with an odd number, three at least, of laser diodes, the diodes with identical wavelengths being positioned symmetrically relative to the adder's optical axis.

With the proposed structure, it is possible to use laser diode sources operating at different wavelengths in order to obtain a resultant beam which would contain different wavelengths without any loss of the achieved brightness, thereby enhancing the efficiency of the adder when working at different wavelengths while maintaining at the same time its compactness and light weight. Such high brightness emitters producing substantially coherent or fully coherent light beams at different wavelengths concentrated along a same optical axis may be applied to TV appliances, diagnostic systems etc.

The essence of the present invention resides in the provision of a light-emitting adder design having beam-transporting means with a predetermined degree of mixing achieved even before shaping a collimated light beam in both directions, with a specific arrangement of components in the beam-shaping means and with substantially equal values, though differing within narrow specified ranges, of the optical lengths and wavelengths of the light sources located in a same plane which is strictly oriented with respect to the emitting surface of each source and to the whole optical system. In addition, the following effects are achieved: a considerable decrease in the dissipation of the beam energy when transferring the beam from each individual emitter to the focusing zone; substantially complete mixing of beams within the acceptance angle, at least within its major part adjoining to the focusing zone, thus allowing to obtain a uniform illumination of the target area in cases where it is placed both within the focusing zone and. provided the use of appropriated optics, farther along the optical axis; a drastic increase in the brightness and the power output density, including the case of using sources with different wavelengths. Moreover, when using an adder provided with laser diodes and at least partly reflecting means, wherein coherence conditions are imposed for the variation of the optical lengths L, mu, and wavelengths $\lambda$, mu, it becomes possible to shape substantially coherent or fully coherent beams of high brightness, as well as single-mode beams. As to the provision of a polarizer, such a solution became possible due to the fact that the required polarization of the system can be only ensured with the claimed laser diodes structure and the proper selection of their parameters which are closely related to the adopted design of the beam-shaping means and the provision of at least partly reflecting means. Therefore, all these essential distinctive features, taken in combination, have allowed to achieve the principal advantages of the claimed adder.

It must be understood that the proposed light-emitting adder may be technologically implemented using known basic processes which are well developed to date and employed in manufacturing lasers and various optical systems.

Brief Description of the Drawings

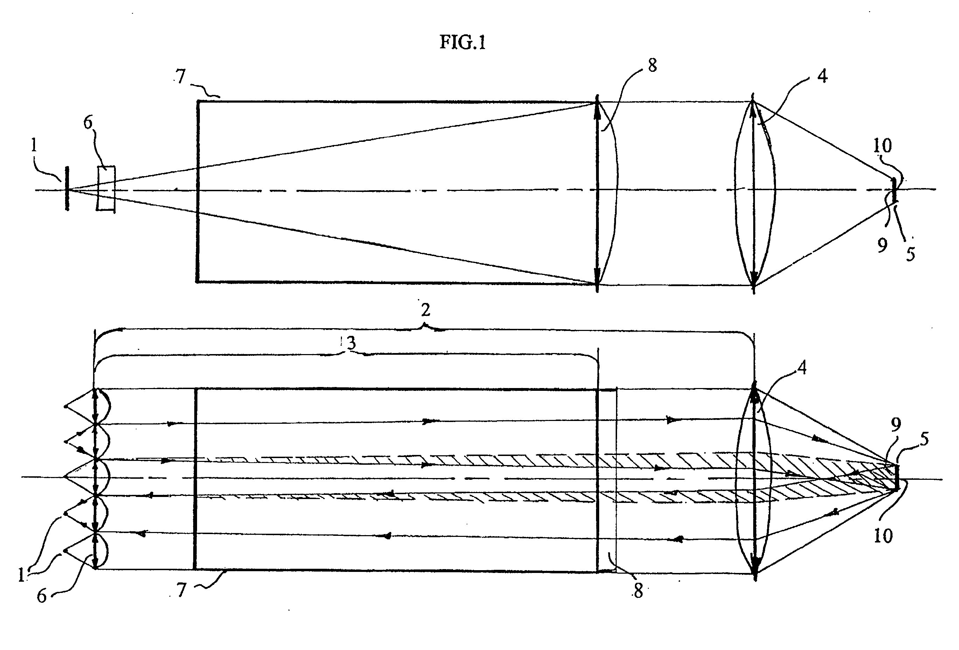

The invention will now be explained in greater detail with reference to particular embodiments thereof represented in the accompanying drawings of Fig. 1 to 3 which are merely exemplary, various other modifications of the light-emitting adder being also conceivable within the spirit and scope as defined in the appended claims.

Fig. 1 is a schematic representation of the longitudinal sections of the light-emitting adder provided with light sources in the form of laser diodes in two planes: x-z and y-z.

Fig. 2 is a schematic representation of the longitudinal section, in the plane x-z, of the light-emitting adder provided with light sources in the form of laser diodes and a target represented by an optical fibre.

Fig. 3 is a schematic representation of the longitudinal section in relation to the embodiment of the light-emitting adder comprising a polarizer.

Description of the Embodiments

Referring now to Fig. 1, the proposed light-emitting adder (called hereinafter "adder") according to the first embodiment comprises light sources 1 (called below "sources"), imaging means 2 composed of shaping means 3 and focusing means 4, and a focusing zone 5. Let us suppose that when describing the first and second embodiments, the x-axis will be directed along the long dimension of the stripe and the y-axis, along its short dimension. Just as in the case of the closest prior art solution (US005463534A, 1995, F04V 7/04, 362/32), it is assumed that the respective sizes of the long side "a" and the short side "b" of the light-emitting stripe must be taken identical for all the sources 1. The light sources are located in a same plane which is perpendicular to the long dimension of the stripes and extends preferably through the centre thereof. The shaping means 3 comprise means 6 collimating along the y-axis, beam-transporting means 7 and means 8 collimating along the x-axis. The focusing zone 5 accommodates at least partly reflecting means 9 and, in the example illustrated, a target area 10. The light sources 1 are spaced apart from the focusing zone 5 at substantially equal distances corresponding to the optical lengths L. The optical lengths L are selected, for each source, such that they differ from one another by not more than a value $\Delta L$, mu, amounting to 2 %-8 %, but not more than 10 %, of the optical lengths L, mu. The target area 10 may be positioned either within the focusing zone 5 or farther on the optical axis. In both cases (in the latter case, provided the use of suitable optics), the target area 10 will be completely occupied by all the beams issuing from the sources 1.

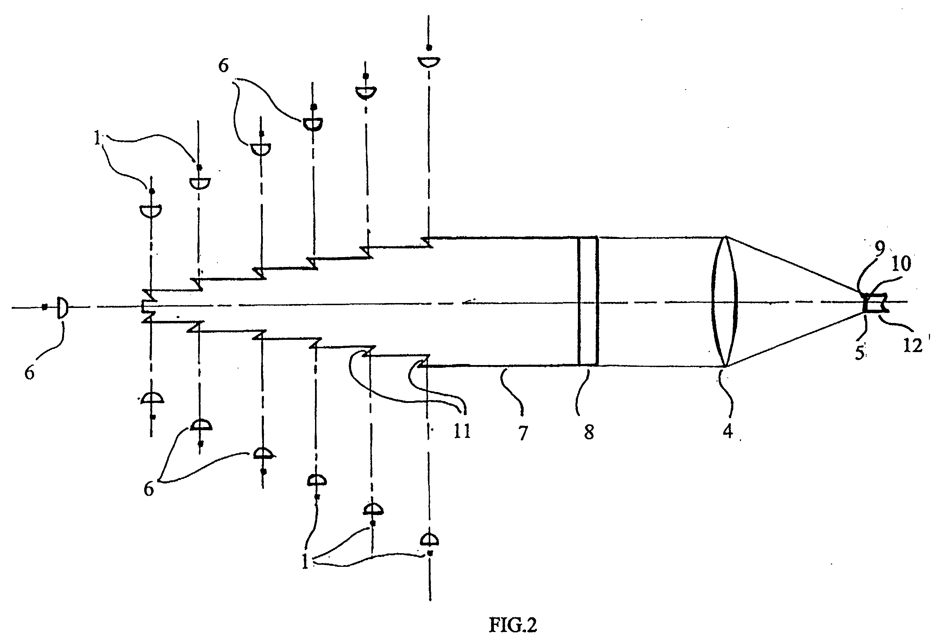

In accordance with the second embodiment (Fig. 2), the claimed light-emitting adder is designed as follows. Used as light sources are laser diodes 1 arranged in a same plane which is perpendicular to the long dimension of the light-emitting stripes and extends preferably through the centre thereof. In this particular case, there are 13 laser diodes 1. The light-emitting elements of the laser diodes 1 are fabricated from a heterojunction structure GaAs-InGaAs having lasing wavelength $\lambda = 670\pm2$ nm with a spread between different diodes lying within the limits $\pm3$ nm. In the cross-section perpendicular to the optical axis of each diode 1, the size of the light-emitting stripe is of $(100 \times 1)$ mu$^2$. Let us agree that the long side is in line with the x-axis and the short side, in line with the y-axis. They are located in the plane y-z which extends through the centres of the respective stripes. We have chosen the combination of deviations $\Delta L$, mu, of the optical lengths and deviations $\delta\lambda$, mu, of the wavelengths, for one pair of laser diodes 1, namely second as viewed from the central one, located symmetrically about the adder's optical axis, such as it satisfies the coherence condition, i.e. $\Delta L \leq \pi \cdot \lambda^2 / 8 \cdot \delta\lambda$. As to the optical lengths L, mu, related to other laser diodes, they are characterized by a spread of $4\pm1$ % of the corresponding optical length L, mu.

As stated above, imaging means 2 are composed of shaping means 3 and focusing means 4. Shaping means 3 include, as viewed from the laser diodes 1, a system of cylindrical lenses 6 ensuring the collimation along the y-axis, which are positioned on each optical axis of the laser diodes 1 and having focal lengths of $0.25\pm0.02$ cm, beam-transporting means 7 provided with input rotating prisms 11 made of glass, and a cylindrical lens 8 collimating the beam along the x-axis with a focal length of $4.6\pm0.2$ cm. Then follow focusing means formed by a focusing lens 4 having identical ($\pm1$ mu) focal lengths along the x-axis and y-axis equal to $2.5\pm0.03$ cm. Mounted farther on the optical axis is a light guide 12 whose end is positioned within the focusing zone 5 and covered with a partly reflecting coating 9 having a reflection factor R in the order of $7\pm0.5$ %.

In operation, the supply of the working current to the laser diodes 1 gives rise to the emission of a coherent light with a predetermined wavelength, or wavelengths, and a corresponding spectral half-width. Passing along the optical paths indicated in Fig. 1 by arrows directed from the sources 1 to the focusing zone 5, the light produced by each of the sources 1 reaches the target area 10 placed within said zone 5. In this travel, a part of the light is reflected from the above-mentioned at least partly reflecting means 9 made in the form of the coating 9 covering the target area 10 and then comes back to the imaging means 2 following, however, another optical paths indicated in Fig. 1 by arrows going in the opposite direction. Here the solid line shows the light leaving the source 1 which is second as viewed from above in Fig. 1, then reflected from the at least partly reflecting means 9 and finally coming back to the source 1 which is second as viewed from below in this Figure. The broken line designates the path of the light emitted by the central source 1 and the hatched regions illustrate examples of beams overlapping.

In the beam-transporting means 7, there is operated a partial mixing of beams (by a value of about $25\pm5$ %). The light collimated in two mutually perpendicular planes attains the focusing means formed by the focusing lens 4 having identical ($\pm1$ mu) focal lengths along the x-axis and y-axis equal to $2.5\pm0.03$ cm. After having passed through said focusing lens 4, the beams will be substantially fully mixed within the acceptance angle of the target area 10 both along the x-axis and the y-axis, thus entirely illuminating, with each original part of the light, the total target area 10, i.e. a square spot of $40 \times 40$ mu$^2$, the divergence in mutually perpendicular directions being equal to $14\pm0.2$ mrad. Said target area 10 is constituted by the end of the optical fibre 12 having a diameter of 50 mu with a numerical aperture NA of the receiving fibre equal to $0.21\pm0.01$. The at least partly reflecting means 9 are made in the form of a coating deposited on the end of said optical fibre 12.

Each laser diode has a power output $P_1$ averaging in the order of $250\pm0.10$ mW. We achieved a resulting power output $P_{out}$ amounting to 1.5 W over an area of $40 \times 40$ mu$^2$. So, it is evident that using few light sources, a considerably greater power output density and a higher brightness are achieved.

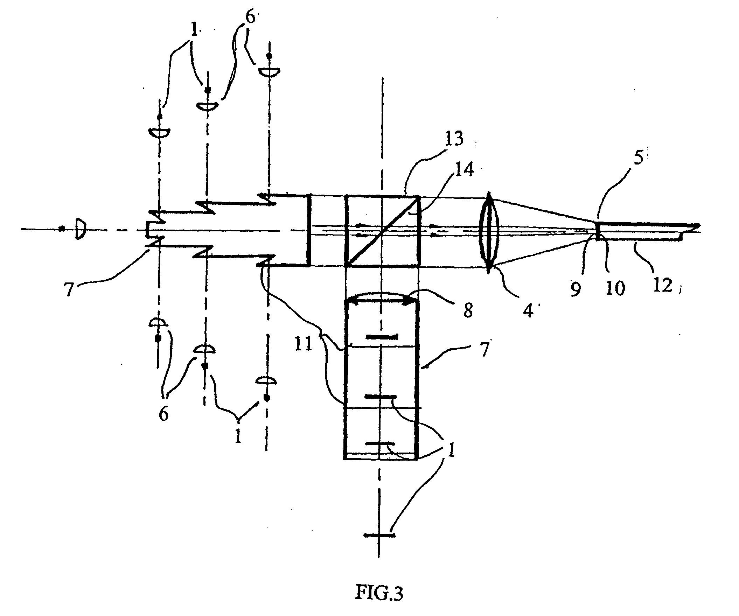

In accordance with the third embodiment (Fig. 3), the claimed light-emitting adder is composed of two systems of laser diodes 1 performing the function of light sources and two shaping means 3 associated with each of said systems of laser diodes 1. The laser diodes 1 are located in two mutually perpendicular planes, each of which is perpendicular to the long dimension of the respective light-emitting stripes and extends preferably through their centre. Each shaping means 3 are composed of a plurality of means 6 collimating in the direction parallel to the short dimension of the light-emitting stripe. The first shaping means 3 further comprise at least one beam-transporting means 7 capable, on at least a part of its extent, of mixing the beams, followed by means 8 collimating in the direction parallel to the long dimension of the stripe. The respective optical axes of the shaping means 3, which constitute those of the beam-transporting means 7 and of the means 8 collimating in the direction parallel to the long dimension of the stripe, are mutually parallel, intersect with one another downstream of the shaping means 3 and upstream of the focusing means 4 and are positioned in the planes corresponding to the location of the laser diodes 1. The planes of location of the laser diodes 1 intersect downstream of the shaping means 3. The above-mentioned optical axes of the shaping means 3 intersect on the line of crossing of said planes of location of the laser diodes 1. The additional polarizer 13 is placed, with its plane of polarization 14, at the intersection of said optical axes of the shaping means 3. Mounted downstream of the polarizer 12 are focusing means 4, while the focusing zone 5 incorporates the at least partly reflecting means 9. The output end of each laser diode 1 is spaced apart from the focusing zone 5 at substantially equal distance corresponding to the optical lengths L, mu. In this system, the combination of deviations $\Delta L$, mu, of the optical lengths and deviations $\delta\lambda$, mu, of the

wavelengths is taken, for at least one pair of laser diodes 1 located symmetrically about the adder's optical axis, such as it satisfies the coherence condition, i.e. $\Delta L \leq \pi \cdot \lambda^2 / 8 \cdot \delta\lambda$, whereas for the remaining laser diodes, the deviation $\Delta L$, mu, of the optical lengths is taken so as not to exceed 10 % of said optical lengths L, mu.

Therefore, the inventors achieved a considerably higher power output density and an increased brightness of the integrated, well-packed and substantially coherent narrow light beam generated by few light sources which may operate at different wavelengths. Furthermore, the beam positioning in such sources, as well as the process of manufacture of the entire system, including its component parts, are made easier.

Industrial Applicability

Light-emitting adders are widely usable in pumping solid-state lasers, in producing laser-based industrial equipment, measuring appliances, medical instrumentation, marking devices, communication facilities, as well as systems for long-distance power and data transmission.

**Claims**

1.  A light-emitting adder comprising at least two light sources with stripe-geometry emission regions in the sections perpendicular to the optical axes of said light sources, the mutually perpendicular sides of the light-emitting stripes at the output ends of said light sources having a long dimension and a short dimension, a target area and imaging means interposed between said light sources and a focusing zone and including beam-shaping means provided with means for collimating beams in mutually perpendicular directions parallel to the sides of said light-emitting stripes, as well as focusing means for focusing onto said focusing zone, the output end of each light source being spaced apart from said focusing zone at distances equal to the optical lengths L, mu, **characterized in that** said light sources are selected in order to allow the emission at one at least wavelength $\lambda$, mu, and are located in a plane perpendicular to the long dimension of said light-emitting stripes, the values of optical lengths are selected within the range $L - \Delta L \ldots L + \Delta L$, where the deviation $\Delta L$, mu, of the optical lengths is taken so as not to exceed 10 % of said optical lengths L, mu, said beam-shaping means forming part of said imaging means are provided, at the light sources' end and for each of them, with means for collimating beams in the direction parallel to the short dimension of each stripe, there is further provided at least one beam-transporting means capable, on at least a part of its extent, of mixing the beams, and downstream of said beam-transporting means within said beam-shaping means there are positioned means for collimating beams in the direction parallel to the long dimension of the stripe.

2.  A light-emitting adder as claimed in claim 1, **characterized in that** said light sources are made in the form of stripe-shaped laser diodes.

3.  A light-emitting adder as claimed in claim 1, **characterized in that** said light sources are made in the form of stripe-shaped superluminescent diodes.

4.  A light-emitting adder as claimed in claim 1, 2 or 3, **characterized in that** the value of deviation $\Delta L$, mu, of the optical lengths is taken equal to 2 % - 8 % of said optical lengths L, mu.

5.  A light-emitting adder as claimed in claim 1 or 2, **characterized in that** the combination of deviations $\Delta L$, mu, of the optical lengths and deviations $\delta\lambda$, mu, of the wavelengths is taken, for at least one pair of laser diodes located symmetrically about the adder's optical axis, so as to satisfy the coherence condition, i.e. $\Delta L \leq \pi \cdot \lambda^2 / 8 \cdot \delta\lambda$.

6.  A light-emitting adder comprising at least two light sources with stripe-geometry emission regions in the sections perpendicular to the optical axes of said light sources, the mutually perpendicular sides of the light-emitting stripes at the output ends of said light sources having a long dimension and a short dimension, a target area and imaging means interposed between said light sources and a focusing zone and including beam-shaping means provided with means for collimating beams in mutually perpendicular directions parallel to the sides of said light-emitting stripes, as well as focusing means for focusing onto said focusing zone, the output end of each light source being spaced apart from said focusing zone at distances equal to the optical lengths L, mu, **characterized in that** said light sources made in the form of laser diodes are selected in order to allow the emission at one at least wavelength $\lambda$, mu, and are located in a plane perpendicular to the long dimension of said light-emitting stripes, said beam-shaping means are provided, at the laser diodes' end and for each of them, with means for collimating beams in the direction parallel to the short dimension of each stripe, there is also provided at least one beam-transporting means capable, on at least a part of its extent, of mixing the beams, there is positioned, downstream of said beam-transporting means within said beam-shaping means, collimating means for collimating beams in the direction parallel to the long dimension of the stripes, and there is further provided, in said focusing zone, at least partly reflecting means, the values of optical lengths L, mu, being selected within the range L - ΔL ... L + ΔL, where ΔL, mu, is deviation of said optical lengths L, mu, and the combination of deviations ΔL, mu, of the optical lengths and deviations δλ, mu, of the wavelengths, for at least one pair of laser diodes located symmetrically about the adder's optical axis, being taken so as to satisfy the coherence condition, i.e. $\Delta L \leq \pi \cdot \lambda^2/8 \cdot \delta\lambda$, whereas for the remaining laser diodes, the deviation ΔL, mu, of the optical lengths is taken so as not to exceed 10 % of said optical lengths L, mu.

7. A light-emitting adder comprising at least two light sources with stripe-geometry emission regions in the sections perpendicular to the optical axes of said light sources, the mutually perpendicular sides of the light-emitting stripes at the output ends of said light sources having a long dimension and a short dimension, a target area and imaging means interposed between said light sources and a focusing zone and including beam-shaping means provided with means for collimating beams in mutually perpendicular directions parallel to the sides of said light-emitting stripes, as well as focusing means for focusing onto said focusing zone, the output end of each light source being spaced apart from said focusing zone at distances equal to the optical lengths L, mu, **characterized in that** at least two additional light sources are provided, all the light sources are made in the form of laser diodes, selected in order to allow the emission at one at least wavelength λ, mu, and arranged so as to have at least two sources in each of two mutually perpendicular planes, each of these planes being perpendicular to the long dimension of the respective light-emitting stripes, said imaging means comprise, in addition to said first beam-shaping means, second beam-shaping means, both said beam-shaping means being coupled to at least two light sources and provided, at said sources' end and for each of them, with means for collimating beams in the direction parallel to the short dimension of the light-emitting stripe, said first beam-shaping means further includes at least one beam-transporting means capable, on at least a part of its extent, of mixing the beams, said second beam-shaping means also incorporate at least one beam-transporting means capable, on at least a part of its extent, of mixing the beams, there is positioned, downstream of said beam-transporting means within each of said beam-shaping means, one collimating means for collimating beams in the direction parallel to the long dimension of the light-emitting stripes, the respective optical axes of said beam-shaping means being mutually perpendicular and there being additionally provided, at their intersection downstream of said beam-shaping means, a polarizer allowing, during the operation of the apparatus, to transmit the collimated beam from one of said beam-shaping means, to cause the total internal reflection of the collimated beam from other of said beam-shaping means, and to obtain a resulting beam on whose axis, downstream of said polarizer, said focusing means are mounted, whereas in said focusing zone there is placed at least partly reflecting means, the values of optical lengths L, mu, being selected within the range L - ΔL ... L + ΔL, where ΔL, mu, is deviation of said optical lengths L, mu, and the combination of deviations ΔL, mu, of the optical lengths and deviations δλ, mu, of the wavelengths, for at least one pair of laser diodes located symmetrically about the adder's optical axis, being taken so as to satisfy the coherence condition, i.e. $\Delta L \leq \pi \cdot \lambda^2 / 8 \cdot \delta\lambda$, whereas for the remaining laser diodes, the deviation ΔL, mu, of the optical lengths is taken so as not to exceed 10 % of said optical lengths L, mu.

8. A light-emitting adder as claimed in claim 1, 2, 3, 4, 5, 6 or 7, **characterized in that** said beam-transporting means are designed with a degree of mixing ranging from 10 % to 40 %.

9. A light-emitting adder as claimed in claim 1, 2, 3, 4, 5, 6, 7 or 8, **characterized in that** beam-transporting means are provided on the trajectory of the beam leaving each light source.

10. A light-emitting adder as claimed in claim 1, 2, 3, 4, 5, 6, 7, 8 or 9, **characterized in that** said beam-transporting means are made with a predetermined variation of the degree of mixing, at least in the plane perpendicular to the long dimension of the light-emitting stripes and in at least one direction.

11. A light-emitting adder as claimed in claim 10 **characterized in that** said beam-transporting means are formed with a predetermined variation of the refractive index.

12. A light-emitting adder as claimed in claim 1, 2, 3, 4, 5, 6, 7, 8, 9, 10 or 11, **characterized in that** the number N of sources is taken, within the acceptable range of variations between 0.5N and 1.5N, integral-valued subject to the condition:

$$N = [b \cdot \sin(\theta_b/2)]/[a \cdot \sin(\theta_a/2)],$$

where a and b are dimensions of the stripe-shaped emission regions of the source for the long side and the short side, respectively, and $\theta_a$ and $\theta_b$ are divergence angles in the direction of the long dimension and the short dimension, respectively.

13. A light-emitting adder as claimed in claim 1, 2, 3, 4, 5, 6, 7, 8, 9, 10, 11 or 12, **characterized in that** the light sources are arranged in such a manner that the centres of their emitting stripes are located in the plane perpendicular to the long dimension of said stripes.

14. A light-emitting adder as claimed in claim 1, 2, 3, 4, 5, 6, 7, 8, 9, 10, 11, 12 or 13, **characterized in that** the target area is placed within the focusing zone.

15. A light-emitting adder as claimed in claim 6, 7, 8, 9, 10, 11, 12, 13 or 14, **characterized in that** the planes of said target area and said at least partly reflecting means are made coincident with one another.

16. A light-emitting adder as claimed in claim 2, 6, 7, 8, 9, 10, 11, 12, 13, 14 or 15, **characterized in that** the laser diodes are made with wavelengths λ, mu, and optical lengths L, mu, such that for any pair of laser diodes located symmetrically about the optical axis of the adder, the combination of deviations ΔL, mu, of the optical lengths and deviations δλ, mu, of the wavelengths satisfies the coherence condition, i.e. $\Delta L \leq \pi \cdot \lambda^2/8 \cdot \delta\lambda$.

17. A light-emitting adder as claimed in claim 16 **characterized in that** at least one of the laser diodes is made with the lowest divergence angles $\theta_a$, $\theta_b$ and spectral half-width.

18. A light-emitting adder as claimed in claim 17 **characterized in that** said laser diode is positioned on the optical axis of the adder, while other diodes are arranged symmetrically with respect to the former.

19. A light-emitting adder as claimed in claim 17 or 18 **characterized in that** said laser diode having the lowest divergence angles $\theta_a$, $\theta_b$ and spectral half-width is of single-mode type.

20. A light-emitting adder as claimed in claim 2, 4, 5, 6, 7, 8, 9, 10, 11, 12, 13, 14, 15, 16, 17, 18 or 19, **characterized in that** the laser diodes are made with at least two values of wavelengths.

21. A light-emitting adder as claimed in claim 20 **characterized in that** at least one beam-shaping means are associated with an odd number, three at least, of laser diodes, the diodes with identical wavelengths being positioned symmetrically relative to the adder's optical axis.

**Amended claims under Art. 19.1 PCT**

1. A light-emitting adder comprising at least two light sources with light-emitting stripes, having a rectangular section, imaging means interposed between said light source and a focusing zone and comprising beam-shaping means, including means for collimating beams arranged in perpendicular planes, parallel to the sides of said light emitting stripes, as well as focusing means, **characterized in that** the centers of the light emitting stripes of the light emitting sources are mainly arranged in a plane, perpendicular to the long sides of the light-emitting stripes, whereas the optical length extending from the outlet end of each of the light emitting source up to the focusing zone is equal to (L ± ΔL), where ΔL is the deviation of the optical length, taken not to exceed 10% of the optical length L, whereas, into the beam-shaping means there is additionally introduced at least one beam-transporting means, capable, at least over part of its extent, of mixing the beams of the light-emitting sources, and the means for collimating beams being made in the form of means for collimating beams arranged in planes, parallel to the short sides of the corresponding light-emitting stripes and arranged at the side of the light-emitting source for each of them, and the means for the collimating emission being arranged in a plane, parallel to the long sides of the stripes and being located after the beam-transporting means.

2. A light-emitting adder as claimed in claim 1, **characterized in that** said light sources are made in the form of stripe-shaped laser diodes.

3. A light-emitting adder, as claimed in claim 1, **characterized in that** said light sources are made in the form of stripe-shaped superluminescent diodes.

4. A light-emitting adder as claimed in any of the claims 1-3, **characterized in that**, the deviation of the optical length ΔL is selected to amount to 2%-8% of L.

5. A light-emitting adder according to claim 2, **characterized in that**, for each of laser diodes of at least one pair of laser diodes, arranged symmetrically with respect to the optical axis of the adder, the deviation of the optical length ΔL is selected to satisfy the coherence condition, i.e. $\Delta L \leq \pi \cdot \lambda^2/8 \cdot \delta\lambda$, where λ is the wavelength of light emission of the corresponding laser diode, δλ is the length deviation of the emission wave.

6. A light-emitting adder comprising at least two light sources with light-emitting stripes, having a rectangular section, imaging means interposed between said light source and a focusing zone and comprising beam-shaping means, including means for collimating beams arranged in perpendicular planes, parallel to the sides of said light emitting stripes, as well as focusing means, **characterized in that** the light sources are made in the form of laser diodes, of which the centers of the light-emitting stripes are prevailingly located in a plane perpendicular to the long sides of the light-emitting stripes, whereas the optical length extending from the outlet end of each of the laser diodes up to the focusing zone is equal to (L ± ΔL), where ΔL is the deviation of the optical length, wherein for each laser diode within at least one pare of laser diodes, arranged symmetrically with respect to the optical axis of the adder, the deviation of the wave length ΔL is selected so as to satisfy the coherence condition, i.e. $\Delta L \leq \pi \cdot \lambda^2 / 8 \cdot \delta\lambda$, where λ is the wave length of light emission of the corresponding laser diode, δλ is the length deviation of the emission wave, whereas for the remaining laser diodes the deviation of the optical length ΔL is selected not to exceed 10% of L, whereas, into the shaping means there is additionally introduced at least one beam+transporting means, capable, at least over part of its extent, of mixing the beams from the laser diodes, and the means for collimating beams being made in the form of means for collimating beams arranged in planes, parallel to the short sides of the corresponding light emitting stripes and arranged at the side of the laser diodes for each of them, and the means for the collimating emission being arranged in planes, parallel to the long sides of the light+emitting stripes and being located after the beam transporting means, whereas in the focusing zone a partially reflecting means is arranged.

7. Light-emitting adder according to claim 6, **characterized in that** there are additionally inserted, at least two laser diodes with light-emitting beams, having a rectangular section, which are arranged in such a manner that the centers of their light-emitting stripes are prevailingly arranged in a plane perpendicular to the plane in which are mainly arranged the centers of light-emitting stripes of other first, at least two, laser diodes, wherein the said planes are perpendicular to the long sides of the light-emitting stripes of the corresponding laser diodes, into the imaging means being introduced additionally a second beam-shaping means, which is optically connected with the corresponding of said additionally introduced at least two laser diodes, into the second-beam shaping means being additionally introduced at least one beam-transporting means, being capable, at least over part of its extent, to mix the emissions, whereas the means for collimating the emissions being arranged in perpendicular planes of the second beam-shaping means made in the form of means collimating the emissions within planes, parallel to the short sides of the corresponding light-emitting stripes, and arranged at the side of the laser diodes for each of them, as well as means for collimating emission arranged in a plane parallel to the long sides of the light emitting stripes, arranged downstream of the beam-transporting means, wherein the optical axes of the beam-shaping means are perpendicular to each other, downstream of the beam-shaping means at the intersections of their optical axes and towards the focusing means there is additionally introduced a polarizator capable of allowing passage to collimated emission from one beam-shaping means and full internal reflexion of collimated emission from the other beam-shaping means for the obtainment of the resulting emission, on the optical axis of its extension a focusing means being arranged, whereas downstream of the focusing means in the focusing zone there being arranged a partially reflecting means, wherein the optical length extending from the outlet end of each of the laser diodes, optically connected with the second beam-shaping means, up to the focusing zone is equal to (L ± ΔL), where ΔL is the deviation of the optical length, wherein for each laser diode of at least one pair of laser diodes, arranged symmetrically with respect to the optical axis of the adder, the deviation of the optical length is selected to satisfy to the coherence condition, i.e $\Delta L \leq \pi \cdot \lambda^2 / 8 \cdot \delta\lambda$, where λ is the deviation of th emission wave length, whereas for the other laser diodes the deviation is selected not to exceed 10% of L.

8. Light-emitting adder according to any of the preceding claims, **characterized in that** the transporting means is shaped with a mixing degree selected in the range 10%...40%.

9. Light-emitting adder according to any of the preceding claims, **characterized in that** the beam-transporting means is made with a given variation of the mixing degree, at least in a plane perpendicular to the long sides of the light-emitting stripes and at least in one direction.

10. A light-emitting adder according to claim 9, **characterized in that** the beam-transporting means is formed with a given variation of the refractive index.

11. A light-emitting adder according to any of the preceding claims, **characterized in that** the quantity of light-emitting sources is taken within the range 05N...1,5N, where N is integral valued subject to the condition

$$N = [a \cdot \sin(\vartheta_a / 2)] / [b \cdot \sin(\vartheta_b / 2)],$$

where a and b are the dimensions of the light-emitting stripes of the light-emitting source for the long and short sides, respectively, whereas $\vartheta_a$ and $\vartheta_b$ are divergency angles in planes parallel to the long and the short sides of the light-emitting stipes, respectively.

**12.** Light-emitting adder according to any of the preceding claims, **characterized in that** the target area is arranged within the focusing zone.

**13.** A light-emitting adder according to any of claims 6-12, **characterized in that** the plane of said target area and said at least partly reflecting means are selected to be coincident with one another.

**14.** A light-emitting adder according to any of claims 2, 6-13, **characterized in that** for any pair of laser diodes, arranged symmetrically with respect to the optical axis of the adder, for each laser diode of a given pair, the deviation of the optical length $\Delta L$ and the deviation of the wave length $\delta\lambda$ are selected to satisfy the coherence condition, i.e. $\Delta L < \pi\cdot\lambda^2/8\cdot\delta\lambda$, where $\lambda$ is the wave length of the corresponding laser diode.

**15.** A light-emitting adder according to claim 16, **characterized in that**, at least one of the laser diodes is made with the lowest divergency angles $\vartheta_a$ and $\vartheta_b$ and spectral half-width.

**16.** A light-emitting adder according to claim 15, **characterized in that** said laser diode is located on the optical axis of the adder, while the other diodes are arranged symmetrical to the former.

**17.** A light-emitting adder according to claims 15 or 16, **characterized in that** the laser diode with the lowest divergency angles $\vartheta_a$ and $\vartheta_b$ and spectral half-width is of single mode type.

**18.** A light-emitting adder according to any of claims 2, 5-17, **characterized that**, at least two laser diodes are made with different values of wavelength.

**19.** A light-emitting adder according to claim 18, **characterized in that**, at least in one beam-shaping means an odd number of laser diodes is selected, while the laser diodes with identical wavelength being positioned symmetrically with respect to the optical axis of the adder.

FIG.1

FIG.2

FIG.3

| INTERNATIONAL SEARCH REPORT | International application No. PCT/RU 98/00363 |
|---|---|

**A. CLASSIFICATION OF SUBJECT MATTER [6]:**
IPC6 H01S 3/25, G02B 6/42, H01S 3/094

*According to International Patent Classification (IPC) or to both national classification and IPC*

**B. FIELDS SEARCHED**

Minimum documentation searched (classification system followed by classification symbols)
IPC6 G02B 6/42, 27/00, 27/10-27/16, 27/48, F21V 5/00-5/04, 7/00-7/04, H01S 3/09, 3/091, 3/094, 3/23, 3/25, H04J 14/00

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | US 5463534 A (DIOMED LIMITED) 31 October 1995 (31.10.95), cited in the description), the abstract , the claims. | 1-21 |
| A | RU 2105399 C1 (GOSUDARSTVENNOE NAUCHNOPROIZVODSTVENNOE PREDPRIYATIE "PRIBOR"), 20 February 1998 (20.02.98) | 1-21 |
| A | US 5081637 A (MASSACHUSETTS INSTITUTE OF TECHNOLOGY) 14 January 1992 (14.01.92), the abstract | 1-21 |
| A | RU 2109384 C1 (PRIVALOV EIGEY MIKHAILOVICH) 20 April 1998 (20.04.98), the abstract | 1-21 |

☐ Further documents are listed in the continuation of Box C.      ☐ See patent family annex.

\*   Special categories of cited documents:

"A"   document defining the general state of the art which is not considered to be of particular relevance

"E"   earlier document but published on or after the international filing date

"L"   document which may throw doubts on priority claim(s) or which is cited to establish the publication date of another citation or other special reason (as specified)

"O"   document referring to an oral disclosure, use, exhibition or other means

"P"   document published prior to the international filing date but later than the priority date claimed

"T"   later document published after the international filing date or priority date and not in conflict with the application but cited to understand the principle or theory underlying the invention

"X"   document of particular relevance; the claimed invention cannot be considered novel or cannot be considered to involve an inventive step when the document is taken alone

"Y"   document of particular relevance; the claimed invention cannot be considered to involve an inventive step when the document is combined with one or more other such documents, such combination being obvious to a person skilled in the art

"&"   document member of the same patent family

| Date of the actual completion of the international search 20 May 1999 (20.05.99) | Date of mailing of the international search report 27 May 1999 (27.05.99) |
|---|---|
| Name and mailing address of the ISA/ R.U. Facsimile No. | Authorized officer Telephone No. |

Form PCT/ISA/210 (second sheet) (July 1992)

16